# EUROPÄISCHE PATENTSCHRIFT

(11) **EP 4 107 004 B1**
(45) Veröffentlichungstag und Bekanntmachung des Hinweises auf die Patenterteilung: **16.10.2024**
(21) Anmeldenummer: 20725090.3
(22) Anmeldetag: 21.04.2020
(51) Int. Cl.: B41J 3/54, B41J 3/28, B41J 11/06, H05K 3/12

(54) **DRUCKERSYSTEM**
PRINTER SYSTEM
SYSTÈME D'IMPRIMANTE

(30) Priorität: 16.05.2019 DE 102019207185
(43) Veröffentlichungstag der Anmeldung: 28.12.2022
(73) Patentinhaber: Siemens Aktiengesellschaft, 80333 München (DE)
(72) Erfinder: MENSING, Matthias, 12045 Berlin (DE)
(74) Vertreter: Siemens Patent Attorneys
(86) Internationale Anmeldenummer: PCT/EP2020/061038
(87) Internationale Veröffentlichungsnummer: WO 2020/229098

(56) Entgegenhaltungen:
- JP-A- 2006 346 593
- JP-A- 2007 289 884
- JP-A- 2008 093 651
- JP-A- 2010 069 707
- JP-A- 2014 195 805
- JP-B2- 5 470 036

## Beschreibung

Die Erfindung bezieht sich auf ein Druckersystem zum Bedrucken von Gegenständen.

Aus der Druckschrift WO 2014/140192 A2, siehe die dortige Figur 11a, ist ein Druckersystem mit einer Druckeinrichtung bekannt, die eine Transportvorrichtung aufweist, die geeignet ist, einen zu bedruckenden Gegenstand entlang einer vorgegebenen Transportrichtung durch einen Druckabschnitt der Druckeinrichtung zu bewegen. Ein erster Druckkopf dient zum Abscheiden eines viskosen Druckmaterials, wobei der erste Druckkopf mittels einer ersten Druckkopfverfahreinrichtung entlang einer ersten Schiebeachse, die quer zur Transportrichtung liegt, verschieblich ist. Ein zweiter Druckkopf dient ebenfalls zum Abscheiden des viskosen Druckmaterials, wobei der zweite Druckkopf mittels einer zweiten Druckkopfverfahreinrichtung entlang einer zweiten Schiebeachse verschieblich ist, die parallel zur ersten Schiebeachse liegt und entlang der Transportrichtung versetzt ist.

Weiterer Stand der Technik ist in der JP 5 470036 B2, JP 2006 346593 A, JP 2008 093651 A, JP 2014 195805 A, JP 2010 069707 A und JP 2007 289884 A offenbart.

Der Erfindung liegt die Aufgabe zugrunde, ein Druckersystem der eingangs angegebenen Art noch weiter zu verbessern.

Diese Aufgabe wird erfindungsgemäß durch ein Druckersystem mit den Merkmalen gemäß Patentanspruch 1 gelöst. Vorteilhafte Ausgestaltungen der erfindungsgemäßen Druckeinrichtung sind in Unteransprüchen angegeben.

Es ist vorgesehen, dass die erste und die zweite Schiebeachse mittels einer von einer Steuereinrichtung ansteuerbaren Verfahreinrichtung jeweils in der Transportrichtung verfahrbar sind.

Ein wesentlicher Vorteil einer solchen Druckereinrichtung ist darin zu sehen, dass bei dieser die erste und zweite Schiebeachse jeweils verfahrbar sind, sodass bei geeigneter Ansteuerung der Schiebeachsen minimale Druckzeiten erreicht werden können.

Als vorteilhaft wird es angesehen, wenn die Verfahreinrichtung von der Steuereinrichtung derart angesteuert wird, dass die Verfahreinrichtung zwischen aufeinanderfolgenden Zeilendruckphasen die erste und die zweite Schiebeachse jeweils gemeinsam unter Beibehaltung eines konstanten Abstands zwischen den Schiebeachsen relativ zu dem zu bedruckenden Gegenstand verfährt. Diese Vorgehensweise ist insbesondere dann vorteilhaft, wenn die zu bedruckende Fläche relativ gleichmäßig zu bedrucken ist.

Als noch vorteilhafter wird es angesehen, wenn die Verfahreinrichtung von der Steuereinrichtung derart angesteuert wird, dass die Verfahreinrichtung jede Schiebeachse jeweils individuell relativ zu dem zu bedruckenden Gegenstand verfährt, wobei jede Schiebeachse jeweils zu ihrer nächsten Druckzeile verfahren wird, sobald der Druck der vorherigen Druckzeile abgeschlossen ist. Diese Vorgehensweise kann insbesondere dann vorteilhaft sein, wenn die zu bedruckende Fläche relativ ungleichmäßig zu bedrucken ist.

Die Steuereinrichtung ist vorzugsweise derart ausgebildet, dass sie für das Drucken einer jeden Druckzeile jeweils die erste und zweite Druckkopfverfahreinrichtung aktiviert und den ersten und zweiten Druckkopf entlang ihrer jeweiligen Schiebeachse verschiebt und die Druckköpfe jeweils zur Abgabe von viskosem Druckmaterial an zu bedruckenden Stellen der jeweiligen Druckzeile aktiviert, und die Verfahreinrichtung derart ansteuert, dass die erste und die zweite Schiebeachse während ihres jeweiligen Zeilendrucks in der Transportrichtung mit derselben Geschwindigkeit verfahren werden, mit der die Transportvorrichtung den zu bedruckenden Gegenstand in der Transportrichtung bewegt.

Bei der letztgenannten Variante ist es vorteilhaft, wenn die Steuereinrichtung die Verfahreinrichtung derart ansteuert, dass die Schiebeachsen zwischen aufeinanderfolgenden Zeilendruckphasen in Transportrichtung jeweils schneller oder langsamer als der zu bedruckende Gegenstand oder entgegen der Transportrichtung bewegt werden, so dass sie jeweils entlang der Transportrichtung relativ zu dem zu bedruckenden Gegenstand versetzt werden und dabei ihre jeweils nächste Druckzeilenposition erreichen.

Die Druckeinrichtung weist vorzugsweise zusätzlich zu dem ersten und zweiten Druckkopf eine Vielzahl an weiteren Druccköpfen auf, die jeweils mittels einer eigenen Druckkopfverfahreinrichtung entlang einer eigenen Schiebeachse verschieblich sind, wobei jede der Schiebeachsen jeweils parallel zur ersten Schiebeachse liegt und entlang der Transportrichtung gegenüber der ersten Schiebeachse mit einem individuellen Versatz versetzt ist. Die Schiebeachsen sind vorzugsweise entlang der Transportrichtung mittels der Verfahreinrichtung jeweils individuell verfahrbar.

Bei der letztgenannten Variante ist es von Vorteil, wenn die Steuereinrichtung die Verfahreinrichtung derart ansteuert, dass die Schiebeachsen während eines jeden Zeilendrucks jeweils in der Transportrichtung mit derselben Geschwindigkeit verfahren werden, mit der die Transportvorrichtung den zu bedruckenden Gegenstand entlang der Transportrichtung bewegt, und zwischen aufeinanderfolgenden Zeilendruckphasen jeweils in der Transportrichtung schneller oder langsamer als der zu bedruckende Gegenstand oder entgegen der Transportrichtung bewegt werden.

Besonders kurze Druckzeiten lassen sich in vorteilhafter Weise erreichen, wenn die Steuereinrichtung derart ausgestaltet ist, dass sie jeder Schiebeachse eine individuelle Anzahl an Druckzeilen und damit eine individuelle Verfahrstrecke relativ zu dem zu bedruckenden Gegenstand zuordnet, und zwar derart, dass der Druckaufwand pro Schiebeachse auf die Schiebeachsen gleichmäßig verteilt ist und alle Schiebeachsen das Ende ihrer individuellen Verfahrstrecke gleichzeitig oder zumindest annähernd gleichzeitig erreichen.

Bei individuellen Verfahrstrecken ist es vorteilhaft, wenn die Steuereinrichtung nach einem Einfahren des zu bedruckenden Gegenstands in den Druckbereich vor dem Beginn des ersten Zeilendrucks den Abstand der Schiebeachsen entlang der Transportrichtung derart einstellt, dass diejenige Schiebeachse, die entlang der Transportrichtung gesehen bezogen auf den eingefahrenen Gegenstand vorn liegt, um die dieser Schiebeachse zugeordnete Verfahrstrecke versetzt zu der vordersten zu bedruckenden Druckzeile liegt und diejenige Schiebeachse, die entlang der Transportrichtung gesehen bezogen auf den eingefahrenen Gegenstand hinten liegt, oberhalb der hintersten zu bedruckenden Druckzeile liegt.

Für den Fall, dass der zu bedruckende Gegenstand entlang der Transportrichtung gesehen kleiner ist als der minimal mögliche Abstand der Schiebeachsen, ist es vorteilhaft, wenn die Steuereinrichtung die Schiebeachsen mittels der Verfahreinrichtung auf eben diesen minimalen Abstand einstellt und außerhalb des zu bedruckenden Gegenstands befindliche Schiebeachsen zwar entlang der Transportrichtung mitbewegt, aber deren Druckköpfe inaktiv lässt.

Mit Blick auf eine Kollisionsvermeidung steuert die Steuereinrichtung die Verfahreinrichtung vorzugsweise derart an, dass der Abstand zwischen benachbarten Schiebeachsen einen vorgegebenen Mindestabstand aufweist, der mindestens so groß wie die Ausdehnung der Druckköpfe in der Transportrichtung ist.

Die Druckeinrichtung weist bevorzugt eine Aufnahmeeinrichtung zur Aufnahme und Lagerung des zu bedruckenden Gegenstands auf. Der zu bedruckende Gegenstand wird vorzugsweise gemeinsam mit der Aufnahmeeinrichtung durch den Druckbereich bewegt.

Die Schiebeachsen liegen vorzugsweise parallel zu der Ebene, in der der zu bedruckende Gegenstand entlang der Transportrichtung transportiert wird.

An bzw. entlang einer oder mehrerer Schiebeachsen können zwei oder mehr Druckköpfe verschieblich angeordnet sein.

Das Druckmaterial ist vorzugsweise Lotpaste. Die Druckeinrichtung ist also vorzugsweise eine Lotpastenbeschichtungseinrichtung.

Die Erfindung betrifft auch ein Druckersystem mit einer Druckerplattform und zumindest zwei Druckeinrichtungen, die nach einem der Ansprüche 1 bis 13 ausgebildet sind.

Um solche Druckeinrichtungen besonders flexibel einsetzen zu können und den Druckvorgang auch bei mehreren zu bedruckenden Gegenständen insgesamt zu beschleunigen, ist vorgesehen, dass die Druckerplattform zumindest eine Eingabe- bzw. Ausgabevorrichtung aufweist, die dazu eingerichtet ist, die Druckeinrichtungen der Druckerplattform von außen zuzuführen und die Druckeinrichtungen von der Druckerplattform nach außen auszugeben, und dass die Druckeinrichtungen auf der Druckerplattform frei bewegbar sind.

Ein besonderer Vorteil des erfindungsgemäßen Druckersystems besteht darin, dass die einzelnen Druckeinrichtungen auf der Druckerplattform quasi individuell und flexibel bewegt werden können und sich dabei an ihren Druckprozess anpassen können. Beispielsweise können einzelne Druckeinrichtungen auf einer Parkposition der Plattform in eine Wartestellung gefahren werden, während andere Druckeinrichtungen die Plattform schneller durchfahren. Einzelne Druckeinrichtungen können sich hierbei überholen, z.B. um kleinere Druckaufträge schneller abarbeiten und die Druckeinrichtung wieder ausgeben zu können. So können mehrere Druckaufträge gleichsam parallel und an den Aufwand des jeweiligen Druckauftrags angepasst abgearbeitet werden. Jede Druckeinrichtung bildet hierbei ein Individuum, das nach Beschickung der Druckerplattform einen jeweiligen Druckauftrag abarbeitet und nach Abschluss des Druckauftrags wieder ausgegeben wird. Die Bewegung der Druckeinrichtungen kann entweder zentral durch eine Fahrweg-Steuereinrichtung der Druckerplattform oder dezentral durch Fahrweg-Steuereinrichtungen der jeweiligen Druckeinrichtungen gesteuert werden. Außerdem können sich die Druckeinrichtungen durch eigene Antriebseinrichtungen, beispielsweise angetriebene Rollen oder Räder, auf der Druckerplattform bewegen oder sie können durch Bewegungseinrichtungen der Druckerplattform, z.B. Transportbänder, -riemen oder -rollen, bewegt werden. Auch Antriebe über Linearmotoren, Ultraschall und Magnetkräfte sind möglich.

Bezüglich der Vorteile und vorteilhafter Ausgestaltungen des erfindungsgemäßen Verfahrens sei auf die obigen Ausführungen im Zusammenhang mit der erfindungsgemäßen Druckeinrichtung und dem erfindungsgemäßen Druckersystem verwiesen. Insbesondere erstreckt sich das Verfahren auch auf den Betrieb von frei beweglichen erfindungsgemäßen Druckeinrichtungen auf einer Druckplattform des erfindungsgemäßen Druckersystems.

Die Erfindung wird nachfolgend anhand von Ausführungsbeispielen näher erläutert, dabei zeigen beispielhaft:
- Figur 1: ein Ausführungsbeispiel einer Druckeinrichtung vor dem Beginn eines Druckvorgangs,
- Figur 2: die Druckeinrichtung gemäß Figur 1 zum Zeitpunkt des Druckbeginns,
- Figur 3: die Druckvorrichtung gemäß den Figuren 1 und 2 während des Druckvorgangs,
- Figur 4: die Druckeinrichtung gemäß den Figuren 1 bis 3 am Ende des Druckvorgangs, und
- Figur 5: ein erfindungsgemäßes Druckersystem mit einer Druckerplattform und mehreren Druckeinrichtungen.

In den Figuren werden der Übersicht halber für identische oder vergleichbare Komponenten stets dieselben Bezugszeichen verwendet.

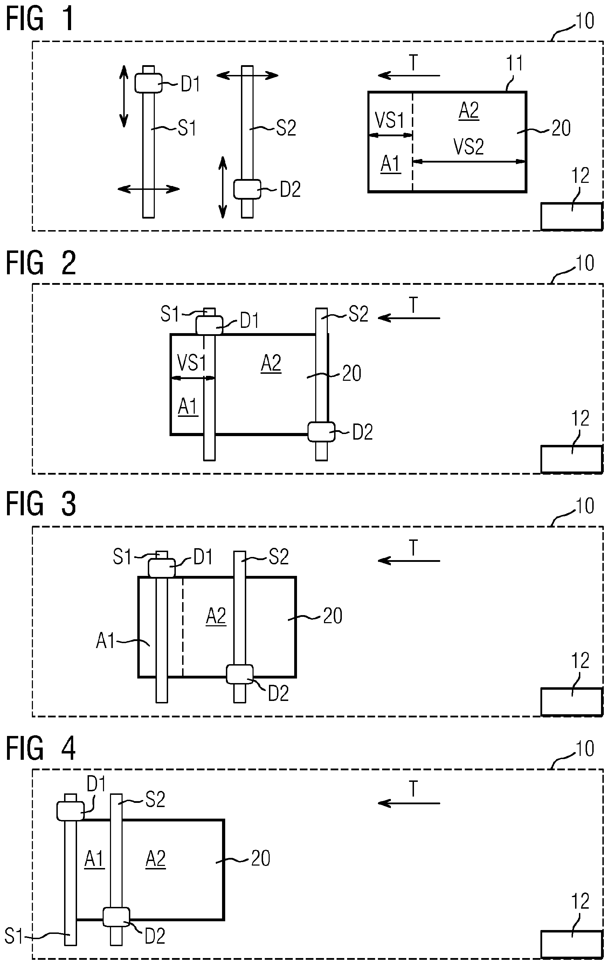

Die Figur 1 zeigt eine Druckeinrichtung 10, die zum Bedrucken eines zu bedruckenden Gegenstandes 20 geeignet ist. Die Druckeinrichtung 10 kann beispielsweise Lotpaste auf eine Leiterplatte aufbringen und eine Lotpastenbeschichtungseinrichtung bilden.

Zum Bedrucken des Gegenstandes 20 wird dieser auf eine Aufnahmeeinrichtung 11 der Druckeinrichtung 10 montiert, die mittels einer nicht weiter dargestellten Transporteinrichtung entlang einer Transportrichtung T in den aktiven Druckbereich der Druckeinrichtung 10 transportiert werden kann. Zur Steuerung der nicht weiter gezeigten Transporteinrichtung dient eine Steuereinrichtung 12 der Druckeinrichtung 10.

Die Druckeinrichtung 10 ist darüber hinaus mit einem ersten Druckkopf D1 und einem zweiten Druckkopf D2 ausgestattet. Der erste Druckkopf D1 ist verschieblich auf einer ersten Schiebeachse S1 montiert und kann entlang dieser ersten Schiebeachse S1 verschoben werden. Zum Verschieben des ersten Drucckopfs D1 auf der ersten Schiebeachse S1 dient eine nicht weiter dargestellte erste Druckkopfverfahreinrichtung, die von der Steuereinrichtung 12 angesteuert wird.

Die erste Schiebeachse S1 ist senkrecht zur Transportrichtung T angeordnet und befindet sich räumlich oberhalb der Ebene, in der der zu bedruckende Gegenstand 20 bzw. die Aufnahmeeinrichtung 11 liegt. Der zu bedruckende Gegenstand 20 kann somit unterhalb der ersten Schiebeachse S1 und unterhalb des ersten Druckkopfes D1 verschoben werden.

Die Druckeinrichtung 10 weist darüber hinaus einen zweiten Druckkopf D2 auf, der auf einer zweiten Schiebeachse S2 verschieblich angeordnet ist und von einer ebenfalls nicht weiter dargestellten zweiten Druckkopfverfahreinrichtung entlang der zweiten Schiebeachse S2 verschoben werden kann. Die zweite Druckkopfverfahreinrichtung wird ebenfalls von der Steuereinrichtung 12 angesteuert.

Die zweite Schiebeachse S2 ist ebenfalls senkrecht zur Transportrichtung T angeordnet und befindet sich wie die erste Schiebeachse S1 räumlich oberhalb der Ebene, in der der zu bedruckende Gegenstand 20 bzw. die Aufnahmeeinrichtung 11 liegt. Der zu bedruckende Gegenstand 20 kann somit auch unterhalb der zweiten Schiebeachse S2 und unterhalb des zweiten Druckkopfes D2 verschoben werden.

Die erste Schiebeachse S1 ist entlang der Transportrichtung T räumlich vor der zweiten Schiebeachse S2 angeordnet, sodass die erste Schiebeachse S1 auch als vorn liegende Schiebeachse und die zweite Schiebeachse S2 als hinten liegende Schiebeachse bezeichnet werden kann.

Die beiden Schiebeachsen S1 und S2 sind jeweils entlang der Transportrichtung T verfahrbar; hierzu weist die Druckeinrichtung 10 für die Schiebeachsen S1 und S2 eine nicht weiter gezeigte Verfahreinrichtung auf, die von der Steuereinrichtung 12 betätigt bzw. angesteuert wird. Jede der beiden Schiebeachsen S1 und S2 ist dabei von der Verfahreinrichtung individuell verfahrbar, sodass der Abstand zwischen den beiden Schiebeachsen S1 und S2 während des Druckvorganges variieren kann.

Vor dem Beginn eines Druckvorgangs wird die Steuereinrichtung 12 zunächst ermitteln, ob sich der Druckaufwand auf der zu bedruckenden Fläche des zu bedruckenden Gegenstandes 20 gleich verteilt oder nicht gleich verteilt. Nachfolgend wird beispielhaft davon ausgegangen, dass der in Transportrichtung T vordere Bereich des zu bedruckenden Gegenstandes 20 einen größeren Druckaufwand erfordert als der hinten liegende Bereich und das Drucken vorn somit zeitlich länger dauert als hinten. Aus diesem Grunde wird die zu bedruckende Fläche des Gegenstandes 20 in zwei Teilflächen A1 und A2 aufgeteilt, deren Druckaufwand gleich oder zumindest näherungsweise gleich ist. Jeder der Teilflächen A1 und A2 kann jeweils eine individuelle Verfahrstrecke VS1 bzw. VS2 zugeordnet werden, die von der der jeweiligen Teilfläche A1 bzw. A2 zugeordneten Schiebeachse S1 bzw. S2 abgefahren bzw. von dem jeweils zugeordneten Druckkopf bedruckt werden soll.

Nachfolgend wird beispielhaft davon ausgegangen, dass die Teilfläche A1 vom vorn liegenden Druckkopf D1 bedruckt werden soll, sodass die vordere Schiebeachse S1 während des Druckvorgangs die Verfahrstrecke VS1 abfahren muss. In entsprechender Weise wird der hinten liegende Druckkopf D2 die Teilfläche A2 bedrucken, sodass die hinten liegende Schiebeachse S2 die Verfahrstrecke VS2 abfahren wird.

Die Figur 2 zeigt die Druckeinrichtung 10 gemäß Figur 1 zum Zeitpunkt des Druckbeginns. Es lässt sich erkennen, dass die Steuereinrichtung 12 den zu bedruckenden Gegenstand 20 bzw. die Aufnahmeeinrichtung 11 in den Bereich der beiden Schiebeachsen S1 und S2 verfahren hat.

Darüber hinaus lässt die Figur 2 erkennen, dass die hinten liegende Schiebeachse S2 auf die - entlang der Transportrichtung T gesehen - hinterste zu bedruckende Druckzeile der Teilfläche A2 bzw. der Verfahrstrecke VS2 verfahren wurde. Die vorn liegende Schiebeachse S1 mit dem vorn liegenden Druckkopf D1 wurde auf die - entlang der Transportrichtung T gesehen - hinterste zu bedruckende Druckzeile der Teilfläche A1 bzw. auf den Beginn der Verfahrstrecke VS1 verfahren.

Die Figur 3 zeigt die Druckeinrichtung 10 während des Druckvorgangs. Es lässt sich erkennen, dass aufgrund des unterschiedlichen Druckaufwands in den beiden Teilflächen A1 und A2 die Schiebeachsen S1 und S2 unterschiedlich schnell entlang der Transportrichtung T gegenüber dem zu bedruckenden Gegenstand 20 verfahren werden können, sodass sich der Abstand zwischen den beiden Schiebeachsen S1 und S2 während des Druckvorgangs verändert.

Die Figur 4 zeigt die Druckeinrichtung 10 zum Zeitpunkt des Abschlusses des Druckvorgangs. Es lässt sich erkennen, dass die vorn liegende Schiebeachse S1 die Verfahrstrecke VS1 abgefahren hat und das Ende der Teilfläche A1 erreicht hat. In entsprechender Weise hat zu diesem Zeitpunkt oder zumindest zeitnah auch die hinten liegende Schiebeachse S2 die Teilfläche A2 fertig bedruckt und das Ende ihrer Verfahrstrecke VS2 erreicht.

Zusammengefasst wird also durch die Aufteilung der zu bedruckenden Fläche in Teilflächen A1 und A2 und durch eine individuelle Ermittlung und Zuordnung von Verfahrstrecken VS1 und VS2 zu der vorn liegenden Schiebeachse S1 und der hinten liegenden Schiebeachse S2 erreicht, dass beide Druckköpfe D1 und D2 bzw. beide Schiebeachsen S1 und S2 zumindest näherungsweise denselben Arbeitsumfang zu absolvieren haben und somit am Ende des Druckvorgangs gleichzeitig oder zumindest näherungsweise gleichzeitig das Ende ihrer individuell zugeordneten Verfahrstrecke VS1 bzw. VS2 erreichen.

Bei dem Ausführungsbeispiel gemäß den Figuren 1 bis 4 wird beispielhaft davon ausgegangen, dass jeder Schiebeachse S1 und S2 jeweils eine individuelle Verfahrstrecke VS1 bzw. VS2 bzw. eine größenmäßig individuelle Teilfläche A1 bzw. A2 zugeordnet wird, damit jeder der Druckköpfe denselben oder zumindest einen ähnlich großen Druckaufwand beim Druckvorgang hat. Alternativ ist es möglich, auf diese Unterscheidung zu verzichten und die Teilflächen A1 und A2 unabhängig vom Druckaufwand stets gleichgroß festzulegen. In diesem Fall können die Schiebeachsen S1 und S2 während des Druckvorgangs mit konstantem Abstand zueinander verfahren werden. Ist der Druckaufwand bei den beiden Teilflächen unterschiedlich groß, so wird die zeitliche Länge des Druckvorgangs durch den Druckaufwand bei der am meisten zu bedruckenden Teilfläche bestimmt.

Bei dem Ausführungsbeispiel gemäß den Figuren 1 bis 4 wird beispielhaft davon ausgegangen, dass die Schiebeachsen S1 und S2 bei dem Drucken einer jeden Druckzeile jeweils mit derselben Transportgeschwindigkeit entlang der Transportrichtung T bewegt werden wie der zu bedruckende Gegenstand 20 bzw. die Aufnahmeeinrichtung 11, sodass das Bedrucken von Druckzeilen senkrecht zur Transportrichtung T erfolgt.

Darüber hinaus wird bei dem Ausführungsbeispiel gemäß den Figuren 1 bis 4 beispielhaft davon ausgegangen, dass die Schiebeachsen S1 und S2 zum Erreichen der jeweils nächsten Druckzeile bzw. zum relativen Verfahren gegenüber dem zu bedruckenden Gegenstand 20 jeweils schneller als der Gegenstand 20 bewegt werden, also entlang der Transportrichtung T gegenüber dem zu bedruckenden Gegenstand 20 verschoben werden. Alternativ ist es möglich, eine relative Verschiebung der Schiebeachsen S1 und S2 entgegen der Transportrichtung T vorzusehen, indem beispielsweise zum Wechsel von Druckzeilen die Schiebeachsen S1 und S2 langsamer entlang der Transportrichtung T bewegt werden als der zu bedruckende Gegenstand 20.

Bei dem Ausführungsbeispiel gemäß den Figuren 1 bis 4 wird - auch aus Gründen der Übersicht - beispielhaft von lediglich zwei Schiebeachsen S1 und S2 ausgegangen; alternativ können auch mehr als zwei Schiebeachsen vorgesehen werden, um die Druckgeschwindigkeit des gesamten Druckvorgangs bzw. des Druckvorgangs insgesamt zu erhöhen.

Bei dem Ausführungsbeispiel gemäß den Figuren 1 bis 4 wird - auch aus Gründen der Übersicht - beispielhaft von lediglich einem Druckkopf pro Schiebeachse ausgegangen; alternativ können auch mehr Druckköpfe pro Schiebeachse vorgesehen werden, um die Druckgeschwindigkeit des gesamten Druckvorgangs bzw. des Druckvorgangs insgesamt zu erhöhen.

Bei dem Ausführungsbeispiel gemäß den Figuren 1 bis 4 wird - auch aus Gründen der Übersicht - beispielhaft lediglich gezeigt, dass die Schiebeachsen parallel zu der Ebene, in der der zu bedruckende Gegenstand entlang der Transportrichtung transportiert wird, bewegt werden; auch ist es möglich, dass die Schiebeachsen zusätzlich senkrecht zu dieser Ebene bewegt bzw. verfahren werden, um den Druckvorgang zu optimieren.

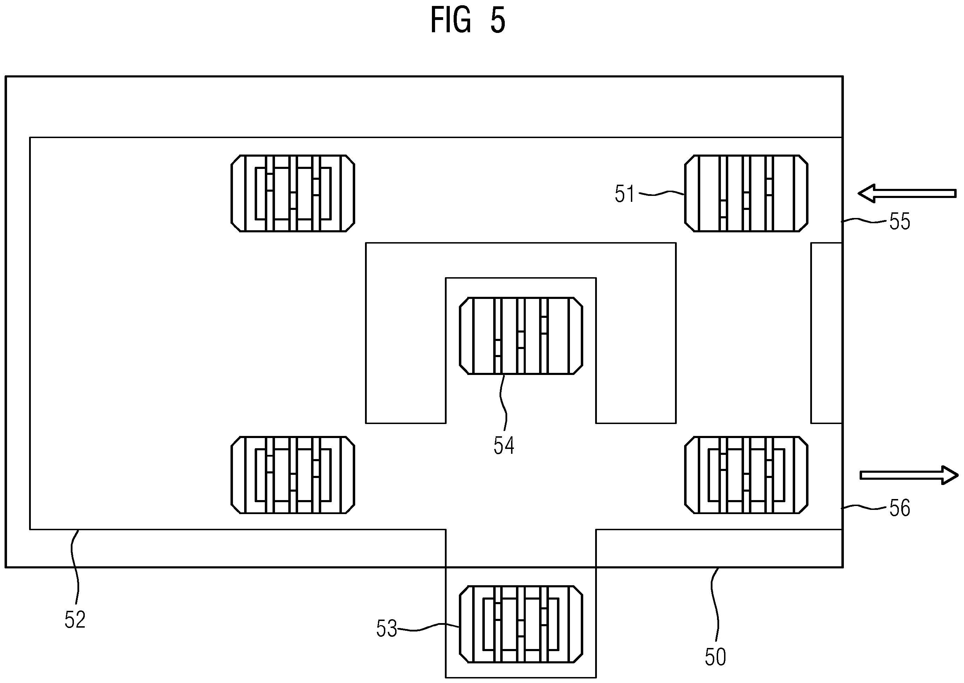

Figur 5 zeigt ein Druckersystem 50 zum Druck viskoser Druckmaterialien (z.B. Lotpaste) auf zu bedruckenden Gegenstände (z.B. Leiterplatten), das eine Druckerplattform 52, eine Eingabevorrichtung 55 zum Bestücken der Druckerplattform 52, eine Ausgabevorrichtung 56 zum Ausgeben von Druckeinrichtungen 51 und zumindest zwei Druckeinrichtungen 51 umfasst, die auf der Druckerplattform frei beweglich sind. Eine Druckeinrichtung umfasst wie zu Figuren 1 - 4 erläutert miteinander verschaltete Komponenten, wie Druckkopfverfahreinrichtungen und eine Transporteinrichtung. Dadurch dass die Druckerplattform 52 eine Mehrzahl von Druckeinrichtungen 51 aufnehmen kann, wird in Kombination eine parallele Bearbeitung von zu bedruckenden Gegenständen mit unterschiedlich komplexen Druckbildern (Druckaufträgen) in gewünschter, auch während des Druckvorganges wechselnder und gleichzeitiger Reihenfolge zugelassen. Dabei werden zuerst die zu bedruckenden Gegenstände in die jeweiligen Druckeinrichtungen 51 eingeführt und diese dann über die Eingabevorrichtung 55 in das Druckersystem eingebracht. Innerhalb des Druckersystems 50 bewegen sich die Druckeinrichtungen 51 frei auf der Druckerplattform 52 und können beispielsweise in eine Parkposition 53 oder einen Aufzug 54 zum Transport auf eine weitere Ebene gefahren werden.

Während der Bewegung auf der Druckerplattform 52 führen die Druckeinrichtungen 51 ihre jeweiligen Druckaufträge aus, wobei ihre Bewegung auf der Plattform an die Art und Dauer des Druckauftrags angepasst wird. Zum Beispiel kann eine Druckeinrichtung 51 auf der Parkposition in eine Wartestellung gefahren werden, um das aufzubringende Substrat abkühlen oder trocknen zu lassen. Währenddessen kann sie von anderen Druckeinrichtungen überholt werden, die einfachere oder kürzere Druckaufträge haben.

Die einzelnen Druckeinrichtungen sind passiv oder aktiv in beliebiger Richtung verfahrbar. Dies beinhaltet auch Kreisbewegungen. Von passiver Verfahrbarkeit wird gesprochen, wenn die Kraft zur Bewegung von außen zugeführt wird, aktiv, wenn die Kraft von der Druckeinrichtung selbst ausgeht. Beides ist gleichzeitig möglich, so dass mindestens eine Druckeinrichtung das eine und gleichzeitig mindestens eine weitere Druckeinrichtung das andere Verfahren zur Bewegung nutzt.

Die Druckeinrichtung bewegt sich frei auf der Druckerplattform und ggf. auch auf internen und/oder externen Leitsystemen, Fahrbahnen, Schienensystemen oder Hebesystemen. Eine zentrale oder dezentrale Fahrweg-Steuereinheit steuert jede Druckeinrichtung individuell und ermöglicht so eine parallele Verarbeitung.

Druckerplattform und jede Druckeinrichtung können über Systeme zur Vibrationsdämpfung verfügen, welche durch eine Steuereinheit einzeln unabhängig voneinander ansteuerbar sind. Dies beinhaltet die Ansteuerung auf Basis voreingestellter Werte, als auch während des Druckvorganges gemessener, errechneter und modellierter Werte.

Über die gleichzeitige Nutzung mehrerer Druckeinrichtungen und ihrer individuellen Ansteuerbarkeit können schnelle Druckvorgänge den Druck durch Überholvorgänge oder vorzeitige Ausschleusung in ihrer individuell benötigten Druckzeit abschließen und müssen nicht in einer Serie auf den vor ihnen liegenden langsamsten Druckvorgang warten.

Die Druckerplattform 52 nimmt alle Elemente auf, welche für den Druckprozess von Nöten sind, aber nicht in den Druckeinrichtungen mitgeführt werden müssen oder sollen.

Abweichend von der in Figur 5 dargestellten Form kann die Druckerplattform 52 auch anderen Ausgestaltungen annehmen und vor allem jede beliebige Form besitzen. Beispielsweise kann die Druckerplattform 52 auch eine kreisförmige Form haben, auf der sich die Druckeinrichtungen karussellartig bewegen.

Neben den oben beschriebenen Funktionen können die Druckeinrichtungen in dem Druckersystem auch zur Aufnahme und Abgabe von Betriebs- und Verbrauchsstoffen, Energie, Restmengen und entleerten Behältern eingerichtet sein und damit Unterstützungsfunktionen für das Druckersystem wahrnehmen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Druckersystem (50) mit einer Druckerplattform (52) und zumindest zwei Druckeinrichtungen (10, 51), die
- eine Transportvorrichtung, die geeignet ist, einen zu bedruckenden Gegenstand (20) entlang einer vorgegebenen Transportrichtung (T) durch einen Druckabschnitt der Druckeinrichtung (10) zu bewegen,
- einen ersten Druckkopf (D1) zum Abscheiden eines viskosen Druckmaterials, wobei der erste Druckkopf (D1) mittels einer ersten Druckkopfverfahreinrichtung entlang einer ersten Schiebeachse (S1), die quer zur Transportrichtung (T) liegt, verschieblich ist, und
- einen zweiten Druckkopf (D2) zum Abscheiden des viskosen Druckmaterials aufweisen,
- wobei der zweite Druckkopf (D2) mittels einer zweiten Druckkopfverfahreinrichtung entlang einer zweiten Schiebeachse (S2) verschieblich ist, die parallel zur ersten Schiebeachse (S1) liegt und entlang der Transportrichtung (T) versetzt ist, und
- wobei die erste und die zweite Schiebeachse (S1, S2) mittels einer von einer Steuereinrichtung (12) ansteuerbaren Verfahreinrichtung jeweils in der Transportrichtung (T) verfahrbar sind,
**dadurch gekennzeichnet, dass**
- die Druckerplattform (52) zumindest eine Eingabe- bzw. Ausgabevorrichtung (55, 56) aufweist, die dazu eingerichtet ist, die Druckeinrichtungen (10, 51) der Druckerplattform (52) von außen zuzuführen und die Druckeinrichtungen (10, 51) von der Druckerplattform (52) nach außen auszugeben; und dass
- die Druckeinrichtungen (10, 51) auf der Druckerplattform (52) frei bewegbar sind.

2. Druckersystem (50) nach Anspruch 1,
**dadurch gekennzeichnet, dass**
die Verfahreinrichtung von der Steuereinrichtung (12) derart angesteuert wird, dass die Verfahreinrichtung zwischen aufeinanderfolgenden Zeilendruckphasen die erste und die zweite Schiebeachse (S1, S2) jeweils gemeinsam unter Beibehaltung eines konstanten Abstands zwischen den Schiebeachsen (S1, S2) relativ zu dem zu bedruckenden Gegenstand (20) verfährt, oder dass
die Verfahreinrichtung von der Steuereinrichtung (12) derart angesteuert wird, dass die Verfahreinrichtung jede Schiebeachse (S1, S2) jeweils individuell relativ zu dem zu bedruckenden Gegenstand (20) verfährt, wobei jede Schiebeachse (S1, S2) jeweils zu ihrer nächsten Druckzeile verfahren wird, sobald der Druck der vorherigen Druckzeile abgeschlossen ist.

3. Druckersystem (50) nach Anspruch 1 oder 2,
**dadurch gekennzeichnet, dass**
die Steuereinrichtung (12) derart ausgebildet ist, dass sie
- für das Drucken einer jeden Druckzeile jeweils die erste und zweite Druckkopfverfahreinrichtung aktiviert und den ersten und zweiten Druckkopf (D1, D2) entlang ihrer jeweiligen Schiebeachse (S1, S2) verschiebt und die Druckköpfe jeweils zur Abgabe von viskosem Druckmaterial an zu bedruckenden Stellen der jeweiligen Druckzeile aktiviert, und
- die Verfahreinrichtung derart ansteuert, dass die erste und die zweite Schiebeachse (S1, S2) während ihres jeweiligen Zeilendrucks in der Transportrichtung (T) mit derselben Geschwindigkeit verfahren werden, mit der die Transportvorrichtung den zu bedruckenden Gegenstand (20) in der Transportrichtung (T) bewegt.

4. Druckersystem (50) nach Anspruch 3,
**dadurch gekennzeichnet, dass**
die Steuereinrichtung (12) derart ausgebildet ist, dass sie die Verfahreinrichtung derart ansteuert, dass die Schiebeachsen (S1, S2) zwischen aufeinanderfolgenden Zeilendruckphasen in Transportrichtung (T) jeweils schneller oder langsamer als der zu bedruckende Gegenstand (20) oder entgegen der Transportrichtung (T) bewegt werden, so dass sie jeweils entlang der Transportrichtung (T) relativ zu dem zu bedruckenden Gegenstand (20) versetzt werden und dabei ihre jeweils nächste Druckzeilenposition erreichen.

5. Druckersystem (50) nach einem der voranstehenden Ansprüche,
**dadurch gekennzeichnet, dass**
- die Druckeinrichtung (10) zusätzlich zu dem ersten und zweiten Druckkopf (D1, D2) eine Vielzahl an weiteren Druckköpfen aufweist, die jeweils mittels einer eigenen Druckkopfverfahreinrichtung entlang einer eigenen Schiebeachse verschieblich sind, wobei jede der Schiebeachsen jeweils parallel zur ersten Schiebeachse (S1) liegt und entlang der Transportrichtung (T) gegenüber der ersten Schiebeachse (S1) mit einem individuellen Versatz versetzt ist, und
- die Schiebeachsen entlang der Transportrichtung (T) mittels der Verfahreinrichtung jeweils individuell verfahrbar sind.

6. Druckersystem (50) nach Anspruch 5,
**dadurch gekennzeichnet, dass**
die Steuereinrichtung (12) die Verfahreinrichtung derart ansteuert, dass die Schiebeachsen (S1, S2) während eines jeden Zeilendrucks jeweils in der Transportrichtung (T) mit derselben Geschwindigkeit verfahren werden, mit der die Transportvorrichtung den zu bedruckenden Gegenstand (20) entlang der Transportrichtung (T) bewegt, und zwischen aufeinanderfolgenden Zeilendruckphasen jeweils in der Transportrichtung (T) schneller oder langsamer als der zu bedruckende Gegenstand (20) oder entgegen der Transportrichtung (T) bewegt werden.

7. Druckersystem (50) nach einem der voranstehenden Ansprüche,
**dadurch gekennzeichnet, dass**
die Steuereinrichtung (12) derart ausgestaltet ist, dass sie jeder Schiebeachse (S1, S2) eine individuelle Anzahl an Druckzeilen und damit eine individuelle Verfahrstrecke (VS1, VS2) relativ zu dem zu bedruckenden Gegenstand (20) zuordnet, und zwar derart, dass der Druckaufwand pro Schiebeachse (S1, S2) auf die Schiebeachsen (S1, S2) gleichmäßig verteilt ist und alle Schiebeachsen (S1, S2) das Ende ihrer individuellen Verfahrstrecke (VS1, VS2) gleichzeitig oder zumindest annähernd gleichzeitig erreichen.

8. Druckersystem (50) nach einem der voranstehenden Ansprüche,
**dadurch gekennzeichnet, dass**
die Steuereinrichtung (12) derart ausgestaltet ist, dass sie nach einem Einfahren des zu bedruckenden Gegenstands (20) in den Druckbereich vor dem Beginn des ersten Zeilendrucks den Abstand der Schiebeachsen (S1, S2) entlang der Transportrichtung (T) derart einstellt, dass diejenige Schiebeachse (S1), die entlang der Transportrichtung (T) gesehen bezogen auf den eingefahrenen Gegenstand (20) vorn liegt, um die dieser Schiebeachse (S1) zugeordnete Verfahrstrecke (VS1) versetzt zu der vordersten zu bedruckenden Druckzeile liegt und diejenige Schiebeachse (S2), die entlang der Transportrichtung (T) gesehen bezogen auf den eingefahrenen Gegenstand (20) hinten liegt, oberhalb der hintersten zu bedruckenden Druckzeile liegt.

9. Druckersystem (50) nach einem der voranstehenden Ansprüche,
**dadurch gekennzeichnet, dass**
die Steuereinrichtung (12) derart ausgestaltet ist, dass sie für den Fall, dass der zu bedruckende Gegenstand (20) entlang der Transportrichtung (T) gesehen kleiner ist als der minimal mögliche Abstand der Schiebeachsen(S1, S2), die Schiebeachsen mittels der Verfahreinrichtung auf eben diesen minimalen Abstand einstellt und außerhalb des zu bedruckenden Gegenstands (20) befindliche Schiebeachsen(S1, S2) beim Zeilendruck zwar entlang der Transportrichtung (T) mitbewegt, aber deren Druckköpfe inaktiv lässt.

10. Druckersystem (50) nach einem der voranstehenden Ansprüche,
**dadurch gekennzeichnet, dass**
die Steuereinrichtung (12) derart ausgestaltet ist, dass sie die Verfahreinrichtung derart ansteuert, dass der Abstand zwischen benachbarten Schiebeachsen einen vorgegebenen Mindestabstand aufweist, der mindestens so groß wie die Ausdehnung der Druckköpfe in der Transportrichtung (T) ist.

11. Druckersystem (50) nach einem der voranstehenden Ansprüche,
**dadurch gekennzeichnet, dass**
die Druckeinrichtung (10) eine Aufnahmeeinrichtung (11) zur Aufnahme und Lagerung des zu bedruckenden Gegenstands (20) aufweist und der zu bedruckende Gegenstand (20) gemeinsam mit der Aufnahmeeinrichtung (11) durch den Druckbereich bewegt wird.

12. Druckersystem (50) nach einem der voranstehenden Ansprüche,
**dadurch gekennzeichnet, dass**
die Schiebeachsen parallel zu der Ebene liegen, in der der zu bedruckende Gegenstand (20) entlang der Transportrichtung (T) transportiert wird.

13. Druckersystem (50) nach einem der voranstehenden Ansprüche,
**dadurch gekennzeichnet, dass**
- an einer oder mehrerer Schiebeachsen zwei oder mehr Druccköpfe verschieblich angeordnet sind und/oder
- das Druckmaterial Lotpaste ist und die Druckeinrichtung (10) eine Lotpastenbeschichtungseinrichtung ist.

## Claims

1. Printer system (50) comprising a printer platform (52) and at least two printing apparatuses (10, 51) which have
- a transport device which is suitable for moving an object (20) to be printed on along a predefined transport direction (T) through a printing portion of the printing apparatus (10),
- a first printing head (D1) for depositing a viscous printing material, wherein the first printing head (D1) is displaceable along a first sliding shaft (S1), which lies transversely with respect to the transport direction (T), by means of a first printing head shifting apparatus, and
- a second printing head (D2) for depositing the viscous printing material,
- wherein the second printing head (D2) is displaceable along a second sliding shaft (S2), which lies parallel to the first sliding shaft (S1) and is offset along the transport direction (T), by means of a second printing head shifting apparatus, and
- wherein the first and the second sliding shaft (S1, S2) are each shiftable in the transport direction (T) by means of a shifting apparatus which is activatable by a control apparatus (12),
**characterized in that**
- the printer platform (52) has at least one input and output device (55, 56) which is configured to supply the printing apparatuses (10, 51) to the printer platform (52) from the outside and to output the printing apparatuses (10, 51) from the printer platform (52) to the outside; and **in that**
- the printing apparatuses (10, 51) are freely movable on the printer platform (52).

2. Printer system (50) according to Claim 1,
**characterized in that**
the shifting apparatus is activated by the control apparatus (12) in such a manner that the shifting apparatus between successive line printing phases shifts the first and the second sliding shaft (S1, S2) in each case jointly relative to the object (20) to be printed on, with a constant distance being maintained between the sliding shafts (S1, S2), or **in that**
the shifting apparatus is activated by the control apparatus (12) in such a manner that the shifting apparatus shifts each sliding shaft (S1, S2) in each case individually relative to the object (20) to be printed on, wherein each sliding shaft (S1, S2) is in each case shifted to its next printing line as soon as the printing of the previous printing line is finished.

3. Printer system (50) according to Claim 1 or 2,
**characterized in that**
the control apparatus (12) is configured in such a manner that it
- for the printing of each printing line in each case activates the first and the second printing head shifting apparatus and displaces the first and second printing head (D1, D2) along their respective sliding shaft (S1, S2) and activates the printing heads in each case for dispensing viscous printing material at points of the respective printing line that are to be printed on, and
- activates the shifting apparatus in such a manner that the first and the second sliding shaft (S1, S2) during their respective line printing are shifted in the transport direction (T) at the same speed at which the transport device moves the object (20) to be printed on in the transport direction (T).

4. Printer system (50) according to Claim 3,
**characterized in that**
the control apparatus (12) is configured in such a manner that it activates the shifting apparatus in such a manner that the sliding shafts (S1, S2) are moved between successive line printing phases in each case more rapidly or slowly than the object (20) to be printed on in the transport direction (T) or counter to the transport direction (T) such that they are in each case offset along the transport direction (T) relative to the object (20) to be printed on and, in the process, reach their next printing line position in each case.

5. Printer system (50) according to one of the preceding claims,
**characterized in that**
- the printing apparatus (10) has, in addition to the first and second printing head (D1, D2), a multiplicity of further printing heads which are each displaceable along a dedicated sliding shaft by means of a dedicated printing head shifting apparatus, wherein each of the sliding shafts in each case lies parallel to the first sliding shaft (S1) and is offset along the transport direction (T) in relation to the first sliding shaft (S1) with an individual offset, and
- the sliding shafts are in each case shiftable individually along the transport direction (T) by means of the shifting apparatus.

6. Printer system (50) according to Claim 5,
**characterized in that**
the control apparatus (12) activates the shifting apparatus in such a manner that the sliding shafts (S1, S2) are each shifted during each line printing in the transport direction (T) at the same speed at which the transport device moves the object (20) to be printed on along the transport direction (T), and, between successive line printing phases, are each moved more rapidly or more slowly than the object (20) to be printed on in the transport direction (T) or counter to the transport direction (T) .

7. Printer system (50) according to one of the preceding claims,
**characterized in that**
the control apparatus (12) is configured in such a manner that it assigns an individual number of printing lines, and therefore an individual shifting section (VS1, VS2) relative to the object (20) to be printed on, to each sliding shaft (S1, S2), specifically in such a manner that the printing effort per sliding shaft (S1, S2) is distributed uniformly between the sliding shafts (S1, S2) and all sliding shafts (S1, S2) reach the end of their individual shifting section (VS1, VS2) simultaneously or at least approximately simultaneously.

8. Printer system (50) according to one of the preceding claims,
**characterized in that**
the control apparatus (12) is configured in such a manner that it after the object (20) to be printed on is brought into the printing region before the beginning of the first line printing adjusts the distance of the sliding shafts (S1, S2) along the transport direction (T) in such a manner that the sliding shaft (S1) which, as seen along the transport direction (T), is located at the front with respect to the brought-in object (20) is located offset with respect to the frontmost printing line to be printed on by the shifting section (VS1) assigned to said sliding shaft (S1) and the sliding shaft (52) which, as seen along the transport direction (T), is located at the rear with respect to the brought-in object (20), is located above the rearmost printing line to be printed on.

9. Printer system (50) according to one of the preceding claims,
**characterized in that**
the control apparatus (12) is configured in such a manner that, in the event that the object (20) to be printed on is smaller, as seen along the transport direction (T), than the minimum possible distance of the sliding shafts (S1, S2), it adjusts the sliding shafts to precisely this minimum distance by means of the shifting apparatus and, although it moves sliding shafts (S1, S2) located outside the object (20) to be printed on along the transport direction (T) during the line printing, it leaves their printing heads inactive.

10. Printer system (50) according to one of the preceding claims,
**characterized in that**
the control apparatus (12) is configured in such a manner that it activates the shifting apparatus in such a manner that the distance between adjacent sliding shafts is a predefined minimum distance which is at least the same size as the extent of the printing heads in the transport direction (T).

11. Printer system (50) according to one of the preceding claims,
**characterized in that**
the printing apparatus (10) has a receiving apparatus (11) for receiving and storing the object (20) to be printed on, and the object (20) to be printed on is moved jointly with the receiving apparatus (11) through the printing region.

12. Printer system (50) according to one of the preceding claims,
**characterized in that**
the sliding shafts are located parallel to the plane in which the object (20) to be printed on is transported along the transport direction (T).

13. Printer system (50) according to one of the preceding claims,
**characterized in that**
- two or more printing heads are arranged displaceably on one or more sliding shafts, and/or
- the printing material is solder paste and the printing apparatus (10) is a solder paste coating apparatus.

## Revendications

1. Système (50) d'imprimante comprenant une plateforme (52) d'imprimante et au moins deux dispositifs (10, 51) d'impression, qui ont
- un mécanisme de transport propre à déplacer un objet (20) à imprimer, suivant un sens (T) de transport donné à l'avance, dans une partie d'impression du dispositif (10) d'impression,
- une première tête (D1) d'impression pour le dépôt d'une matière d'impression visqueuse, dans lequel la première tête (D1) d'impression est, au moyen d'un premier dispositif de déplacement de tête d'impression, coulissante le long d'un premier axe (S1) de coulissement, qui est transversal au sens (T) de transport, et
- une deuxième tête (D2) d'impression pour le dépôt de la matière d'impression visqueuse,
- dans lequel la deuxième tête (D2) d'impression est, au moyen d'un deuxième dispositif de déplacement de tête d'impression, coulissante le long d'un deuxième axe (52) de coulissement, qui est parallèle au premier axe (S1) de coulissement est qui est décalé suivant le sens (T) de transport, et
- dans lequel le premier et le deuxième axes (S1, S2) de coulissement peuvent, au moyen d'un dispositif de déplacement pouvant être commandé par un dispositif (12) de commande, être déplacés respectivement dans le sens (T) de transport,
**caractérisé en ce que**
- la plateforme (52) d'imprimante a au moins un mécanisme (55, 56) d'entrée et de sortie, qui est agencé pour apporter de l'extérieur les dispositifs (10, 51) d'impression à la plateforme (52) de l'imprimante et pour faire sortir les dispositifs (10, 51) d'impression à l'extérieur de la plateforme (52) de l'imprimante ; et **en ce que**
- les dispositifs (10, 51) d'impression peuvent se déplacer librement sur la plateforme (52) de l'imprimante.

2. Système (50) d'imprimante suivant la revendication 1,
**caractérisé en ce que**
le dispositif de déplacement est commandé par le dispositif (12) de commande, de manière à ce que le dispositif de déplacement déplace, par rapport à l'objet (20) à imprimer, entre deux phases d'impression de lignes successives, le premier et le deuxième axes (S1, S2) de coulissement respectivement conjointement en conservant une distance constante entre les axes (S1, S2) de coulissement, ou **en ce que**
le dispositif de déplacement est commandé par le dispositif (12) de commande, de manière à ce que le dispositif de déplacement déplace chaque axe (S1, S2) de coulissement respectivement individuellement par rapport à l'objet (20) à imprimer, dans lequel chaque axe (S1, S2) de coulissement est déplacé respectivement vers sa ligne d'impression suivante, dès que l'impression de la ligne d'impression précédente est terminée.

3. Système (50) d'imprimante suivant la revendication 1 ou 2, **caractérisé en ce que**
le dispositif (12) de commande est constitué, de manière à ce que
- pour l'impression de chaque ligne d'impression, il active respectivement le premier et le deuxième dispositifs de déplacement de tête d'impression et déplace la première et la deuxième têtes (D1, D2) d'impression le long de leur axe (S1, S2) de coulissement respectif et active les têtes d'impression respectivement pour la distribution de matière d'impression visqueuse aux endroits à imprimer de la ligne d'impression respective, et
- il commande le dispositif de déplacement, de manière à déplacer les premier et deuxième axes (S1, S2) de coulissement pendant son impression de lignes respective dans le sens (T) de transport à la même vitesse que celle à laquelle le mécanisme de transport déplace l'objet (20) à imprimer dans le sens (T) de transport.

4. Système (50) d'imprimante suivant la revendication 3,
**caractérisé en ce que**
le dispositif (12) de commande est constitué, de manière à commander le dispositif de déplacement, de manière à déplacer les axes (S1, S2) de coulissement entre des phases d'impression de lignes successives suivant le sens (T) de transport respectivement plus vite ou plus lentement que l'objet (20) à imprimer ou dans le sens (T) contraire au sens de transport, de manière à ce qu'ils soient décalés respectivement suivant le sens (T) de transport par rapport à l'objet (20) à imprimer et atteignent ainsi leur position de lignes d'impression suivante respective.

5. Système (50) d'imprimante suivant l'une des revendications précédentes,
**caractérisé en ce que**
- le dispositif (10) d'impression a, en plus de la première et de la deuxième têtes (D1, D2) d'impression, une pluralité d'autres têtes d'impression, qui peuvent coulisser respectivement au moyen d'un dispositif de déplacement de tête d'impression propre le long d'un axe de coulissement propre, dans lequel chacun des axes de coulissement est respectivement parallèle au premier axe (S1) de coulissement et est décalé d'un décalage individuel suivant le sens (T) de transport par rapport au premier axe (S1) de coulissement, et
- les axes de coulissement peuvent être déplacés individuellement chacun suivant le du sens (T) de transport au moyen du dispositif de déplacement.

6. Système (50) d'imprimante suivant la revendication 5,
**caractérisé en ce que**
le dispositif (12) de commande commande le dispositif de déplacement, de manière à déplacer les axes (S1, S2) de coulissement pendant chaque impression de lignes respectivement dans le sens (T) de transport à la même vitesse que celle à laquelle le mécanisme de transport déplace l'objet (20) à imprimer suivant le sens (T) de transport, et de manière à les déplacer entre des phases d'impression de lignes respectivement dans le sens (T) de transport plus rapidement ou plus lentement que l'objet (20) à imprimer ou dans le sens contraire au sens (T) de transport.

7. Système (50) d'imprimante suivant l'une des revendications précédentes,
**caractérisé en ce que** le dispositif (12) de commande est conformé, de manière à ce qu'il associe à chaque axe (S1, S2) de coulissement, un nombre individuel de lignes d'impression et ainsi une course (VS1, VS2) de déplacement individuelle par rapport à l'objet (20) à imprimer, et cela de manière à répartir uniformément sur les axes (S1, S2) de coulissement la dépense d'impression par axe (S1, S2) de coulissement et tous les axes (S1, S2) de coulissement atteignent en même temps ou au moins à peu près en même temps la fin de leur course (VS1, VS2) de déplacement individuelle.

8. Système (50) d'imprimante suivant l'une des revendications précédentes,
**caractérisé en ce que**
le dispositif (12) de commande est conformé de manière à régler, après l'entrée de l'objet (20) à imprimer dans la zone d'impression, avant le début de la première impression de lignes, la distance entre les axes (S1, S2) de coulissement suivant le sens (T) de transport, de manière à ce que l'axe (S1) de coulissement, qui, considéré suivant le sens (T) de transport, est en avant, rapporté à l'objet (20) qui est entré, soit, de la course (VS1) de déplacement associée à cet axe (S1) de coulissement, décalé par rapport à la plus en avant des lignes d'impression à imprimer, et de manière à ce que l'axe (52) de coulissement, qui, considéré suivant le sens (T) de transport, est en arrière, rapporté à l'objet (20) qui est entré, soit au-dessus de la ligne d'impression à imprimer la plus en arrière.

9. Système (50) d'imprimante suivant l'une des revendications précédentes,
**caractérisé en ce que**
le dispositif (12) de commande est conformé de manière à, dans le cas où l'objet (20) à imprimer est, considéré dans le sens (T) de transport, plus petit que la distance minimum possible entre les axes (S1, S2) de coulissement, régler les axes de coulissement au moyen du dispositif de déplacement à cette distance minimum et à déplacer des axes (S1, S2) de coulissement se trouvant à l'extérieur de l'objet (20) à imprimer, lors de l'impression de lignes, certes suivant le sens (T) de transport, mais en laissant leurs têtes d'impression inactives.

10. Système (50) d'imprimante suivant l'une des revendications précédentes,
**caractérisé en ce que**
le dispositif (12) de commande est conformé, de manière à commander le dispositif de déplacement, de manière à ce que la distance entre des axes de coulissement voisins ait une distance minimum donnée à l'avance, qui est au moins aussi grande que l'étendue des têtes d'impression dans le sens (T) de transport.

11. Système (50) d'imprimante suivant l'une des revendications précédentes,
**caractérisé en ce que**
le dispositif (10) d'impression a un dispositif (11) de réception pour la réception et le montage de l'objet (20) à imprimer et l'objet (20) à imprimer est déplacé conjointement avec le dispositif (11) de réception dans la partie d'impression.

12. Système (50) d'imprimante suivant l'une des revendications précédentes,
**caractérisé en ce que**
les axes de coulissement sont parallèles au plan, dans lequel l'objet (20) à imprimer est transporté suivant le sens (T) de transport.

13. Système (50) d'imprimante suivant l'une des revendications précédentes,
**caractérisé en ce que**
- deux ou plusieurs têtes d'impression sont montées coulissantes sur un ou plusieurs axes de coulissement et/ou
- la matière d'impression est une pâte de brasure et le dispositif (10) d'impression est un dispositif d'application d'une couche de pâte de brasure.
